(19)

Europäisches
Patentamt
European
Patent Office
Office européen
des brevets

(11) **EP 1 970 734 B1**

(12) **EUROPEAN PATENT SPECIFICATION**

(45) Date of publication and mention
of the grant of the patent:
**14.09.2011 Bulletin 2011/37**

(51) Int Cl.:
**G02B 5/30** *(2006.01)* **G03F 7/20** *(2006.01)*

(21) Application number: **08004418.3**

(22) Date of filing: **10.03.2008**

(54) **A method of fabricating a space-variant liquid-crystal waveplate**

Herstellungsverfahren für eine räumlich veränderliche Flüssigkristall-Verzögerungsplatte

Procédé de fabrication de lame de retardement à cristal liquide avec une variation spatiale

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **12.03.2007 US 894255 P**

(43) Date of publication of application:
**17.09.2008 Bulletin 2008/38**

(73) Proprietor: **JDS Uniphase Corporation
Milpitas, CA 95035 (US)**

(72) Inventors:
• **Shemo, David M.
Winsor
California 95492 (US)**
• **McEldowney, Scott
Winsor
California 95492 (US)**
• **Zieba, Jerry
Santa Rosa
California 95405 (US)**

(74) Representative: **Walker, Stephen et al
Murgitroyd & Company
Scotland House
165-169 Scotland Street
Glasgow G5 8PL (GB)**

(56) References cited:
**US-A1- 2004 179 158**

• STALDER M ET AL: "LINEARLY POLARIZED
LIGHT WITH AXIAL SYMMETRY GENERATED BY
LIQUID-CRYSTAL POLARIZATION
CONVERTERS" OPTICS LETTERS, OSA,
OPTICAL SOCIETY OF AMERICA,
WASHINGTON, DC, US, vol. 21, no. 23, 1
December 1996 (1996-12-01), pages 1948-1950,
XP000639753 ISSN: 0146-9592
• CHEN J ET AL: "RADIALLY AND AZIMUTHALLY
ORIENTED LIQUID CRYSTAL ALIGNMENT
PATTERNSFABRICATED BY LINEARLY
POLARIZED ULTRAVIOLET EXPOSURE
PROCESS" APPLIED PHYSICS LETTERS, AIP,
AMERICAN INSTITUTE OF PHYSICS, MELVILLE,
NY, vol. 68, no. 7, 12 February 1996 (1996-02-12),
pages 885-887, XP000559952 ISSN: 0003-6951
• HUBERT SEIBERLE ET AL: "38.1: Invited Paper:
Photo-Aligned Anisotropic Optical Thin Films"
SID'03 DIGEST, 18 May 2003 (2003-05-18), pages
1162-1165, XP007008324

EP 1 970 734 B1

## Description

### TECHNICAL FIELD

The present invention generally relates to wave plates having spatially varying orientation of the optic axis, and particularly relates to a method of fabricating photo-aligned space-variant liquid crystal waveplate.

### BACKGROUND OF THE INVENTION

A wave plate, or an optical retarder, is an optical device that alters the polarization state of incident light by adding a pre-determined phase shift between two orthogonal polarization components of an incident light field. Conventionally, the added phase shift is referred to as the waveplate retardance and is measured in fractions of a wavelength, so that a wave plate that adds a phase shift of $\pi$ between the orthogonal polarizations is referred to as a half-wave plate, and a waveplate that adds a phase shift of $\pi/2$ is referred to as a quarter wave plate.

A wave plate can be made from a birefringent material of a selected thickness having its optic axis in the plane of the wave plate; such a waveplate is also called an a-plate. A material having birefringent properties has different refractive indexes and light transmission speeds for light polarized in different, usually orthogonal, directions. In any birefringent material there is at least one axis, called optic axis, such that light propagating in the direction of the axis in the material has the same speed, regardless of its state of polarization. When a beam of light is passed through a birefringent material normal to its optic axis and is linear polarized at an angle to the optic axis, the birefringent material breaks up the light into ordinary and extraordinary rays, which are linearly polarized in mutually perpendicular directions and travel through the material at different speeds resulting in a phase shift between these rays. When light incident on a waveplate is linearly polarized along the optic axis of the waveplate or at 90 degrees thereto, i.e. has its electric field vector parallel or perpendicular to the optic axis of the waveplate, the polarization of the light is an eigenpolarization of the waveplate and is not changed by the waveplate. Linear polarized light incident on a halfwave plate which polarization state is not an eigenpolarization of the waveplate will be rotated by an amount that is twice the angle between the orientation of the linear polarized light and the optical axis of the retarder.

Conventional applications typically utilize spatially-uniform wave plates to obtain uniformly-polarized beams, i.e. beams of polarized optical radiation which polarization state does not vary across the beams' cross-section. Recently, however, it has been recognized that inducing spatial polarization variations across a uniformly polarized beam is an invaluable wavefront shaping tool. Indeed, if such a beam with space-variant polarization is then analyzed using a linear polarizer, a net effect is an addition of a spatially-variant phase shift, known as the Pancharatnam-Berry phase, across the beam's cross-section. Resulting in a specific shaping of the beams' wavefront. Spatially variant wave plates have therefore attracted considerable interest as they can be used to form linearly polarized optical beams in which the polarization orientation, i.e. the direction of the electric field vector of the beam radiation, varies across the beam's cross-section; see for example an article by M. Stalder and M. Schadt entitled "Linearly polarized light with axial symmetry generated by liquid-crystal polarization converters", Opt. Letts., Vol. 21, No. 23, pp. 1948-1950, Dec. 1, 1996.

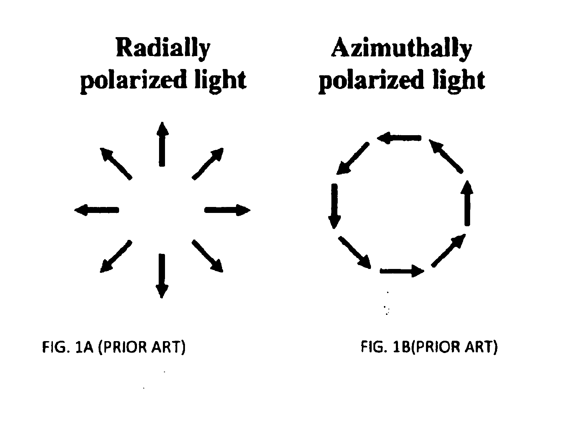

Typical examples of such beams of spatially-variant linear polarization are radially-polarized and tangentially-polarized beams, which sometimes are also referred to simply as radial and tangential beams, respectively. The tangentially-polarized beams may also be referred to as azimuthally-polarized beams. The polarization patterns of these beams are illustrated in FIGs. 1A and 1B, wherein arrows schematically show local orientation of the beam polarization. In both cases, the polarization direction depends only upon an azimuth angle $\varphi$ of the particular spatial location and is independent on the radial distance r from the beam axis. These types of polarized beams are sometimes referred to in the art as cylindrical vector beams or polarization vortex beams. The term "polarization vortex" reflects the fact that the polarization state rotates about the beam axis and is undefined at the axis of such beams, so that the beam adopts a zero intensity at the beam's axis. Such polarization vortex beams have unique properties that can be used in a variety of practical applications such as for particle trapping (optical tweezers), microscope resolution enhancement, free space communications, and lithography.

Tangential and radial beams such as those shown in FIGs. 1A, B are two examples of polarization vortex beams. The term *"polarization vortex* beam," is used herein to refer to optical beams of spatially variant polarization that show a continuous change in the polarization direction through an azimuthal rotation of $2\pi$ radians, or multiples thereof, when traversing a closed loop, for example a circular path, about the axis of the beam. An optical vortex is a point in a beam cross-section which exhibits a phase anomaly so that the electrical field of the beam radiation evolves through a multiple of $2\pi$, in any circular path traced about that point. A *polarization vortex* is a linearly polarized state in which the direction of polarization similarly evolves through a multiple of $2\pi$ about the beam axis.

It is also well established that a polarized plane wave can be described by a 2 dimensional complex vector called a Jones Vector. The Jones vector for a linear polarization vortex in polar coordinates is given by the following equation (1):

$$J_{PV}(m,\varphi) = \begin{pmatrix} \cos\left(m\,\varphi_l + \varphi_{l0}\right) \\ \sin\left(m\,\varphi_l + \varphi_{l0}\right) \end{pmatrix}. \qquad (1)$$

Here, in is the polarization order of the vortex; in also represents the number of rotations of the electric field orientation per azimuthal rotation; $\varphi_1$ is the azimuthal angle. $\theta_{10}$ is a constant parameter which is equal to 0 for the radial beam and to $\pi/2$ radian for the tangential beam. Generally, a vortex beam which is described by equation (1) is referred to as a polarization vortex beam of $m^{th}$ order.

Optical beams which polarization varies across the beams' cross-section can be formed by passing a uniformly linearly polarized light through a spatially variant half-wave plate that has a uniform retardation of $\pi$ radians across the plate and an optic axis that varies in the plane of the waveplate, which is normal to the direction of the beam propagation. Several approaches have been adopted in the art to form such spatially variant waveplates. U.S. Patents 6,972,906, 7,190,521, and U.S. Patent application 2006/0126183 in the name of Erez describe space variant polarization optical elements for spatially manipulating polarization dependent geometrical phases of an incident light beam. The element includes a plurality of zones of sub-wavelength polarization gratings with a continuously varying orientation which is formed in a substrate that is optically transmissive at an operating wavelength. One drawback of this approach is a difficulty in fabrication of gratings with sub-wavelength features in the visible in near-infrared wavelength range; the experiments described by Erez have been performed at far-infrared wavelengths (10.6 $\mu$m) for which the grating features are practical to make.

U.S. Patent Application 2007/0115551 to Spilman and Brown discloses a space-variant waveplate for polarization conversion wherein spatial variation in the orientation of the optic axis are induced by externally applied stress to a glass plate. The method indeed provides a waveplate with a continuously varying optic axis orientation, but may only create a very small annulus where $\pi$ retardance is achieved, and may be sensitive to thermally-induced stresses, which significantly limits its applications.

An attractive approach to fabrication of space-variant wave plates is to utilize well-developed liquid crystal (LC) technologies. Chen et al, in an article entitled "Radially an azimuthally oriented liquid crystal alignement patterns fabricated by linearly polarized ultraviolet light", Appl. Phys. Lett. 68 (7), 12 February 1996, pp. 885-887, and Stadler et al, in the article referred to hereinabove, disclose polarization converters based on twisted nematic (TN) LC elements having space variant optic axes that are defined by tangential or radial alignment patterns, which can be fabricated by photo-exposure to polarized UV light (Chen) and substrate rubbing (Stadler).

These approaches have a common disadvantage that vortex beams of the polarization vortex order greater than $m$=2 cannot be generated, or require multiple optical elements to be generated. Another disadvantage is the use of TN LC materials for the waveplates, which required two pre-aligned substrates for each waveplate. Furthermore, the TN mode LC is known to have limitations in optical power handling capabilities. Seiberle et al, in an Invited Paper entitled "Photo-Aligned Anisotropic Optical Thin Films", SID 03 Digest, pp. 1162-116, provides a review of an alternative LPP/LCP technology related to photo-aligned anisotropic optical thin films, which is based on a combination of linear photo-polymerization (LPP) materials as alignment layers with liquid crystal polymer materials (LCP) as birefringent films. Seiberle et al generally disclose the possibility of fabricating alignment patterns with a continuous azimuthal variation of the alignment direction by synchronized movement and rotation of an LPP-substrate and a polarizer, respectively, while the LPP-layer is exposed through a slit mask. The US Patent Application No 2004/179158 to Silverstein et al discloses creating a patterned polarization compensator for compensating a spatially variant retardance of a spatial light modulator using the general technique of Seiberle et al. In particular, the spatial light modulator is first scanned to measure the spatially variant retardance thereof, and then a corrective spatially variant retardance that corresponds to the measured retardance pattern of the spatial light modulator is scan printed into a compensator using a process that includes writing a spatially variant photo-alignment pattern on a substrate having a photo-alignment layer, and then depositing and fixing a liquid crystal polymer layer to form the spatially variant retardance pattern that compensates for the spatially varying retardance of the spatial light modulator. Notably, nether Seiberle et al nor Silverstein et al discuss how to use the LPP/LCP technology to fabricate space-variant waveplates capable of converting a uniformly linearly polarized light into a polarization vortex beam of any particular vortex order.

An object of the present invention is to overcome the shortcomings of the prior art by providing a relatively simple and inexpensive method and system for fabricating stable liquid crystal based space-variant waveplates capable of converting a uniformly linearly polarized light into a polarization vortex beam of an arbitrary pre-defined order.

Another object of the present invention is to provide stable photo-aligned space-variant liquid-crystal waveplates that are capable of converting a uniformly linearly polarized light into a polarization vortex beam of an arbitrary pre-defined order.

Another object of the present invention is to provide a relatively simple and inexpensive method and system for aligning a substrate with polarized light for forming thereon a space-variant liquid crystal waveplate.

## SUMMARY OF THE INVENTION

In accordance with the invention, a method of fabricating a space-variant wave plate is provided as defined by claim 1. The alignment layer may be formed on a substrate that is preferably substantially transparent or reflective to optical radiation in an operating wavelength range.

In accordance with one aspect of the invention, the aperture has a wedge-shaped portion with a vertex end, and wherein the vertex end is positioned on an axis of rotation of the aperture if the aperture is rotated in step (b), or on an axis of rotation of the alignment layer if the alignment layer is rotated in step (b).

According to another aspect of the invention, step (b) may comprise: performing at least one full rotation of the substrate at a first angular velocity $\omega_1$ while keeping the aperture stationary with the vertex end of the aperture positioned on an axis of rotation of the substrate and while rotating the polarization orientation of the polarized radiation at a second *angular velocity* $\omega_2 = (1\text{-}n/2) \cdot \omega_1$, wherein n is an integer; or step (b) may comprise performing at least one rotation of the aperture about the vertex end thereof at a third angular velocity $\omega_3$, while keeping the substrate stationary and rotating the polarization orientation of the polarized radiation at a forth *angular* velocity $\omega_4 = (n/2\text{-}1) \cdot \omega_3$, wherein n is an integer; or, rotating the aperture at a fifth angular velocity $\omega_5$ while keeping the polarization orientation of the polarized radiation stationary and rotating the substrate at a sixth *angular velocity* $\omega_6 = (1\text{-}2/n) \cdot \omega_5$, wherein *n* is an integer, so that the aperture performs at least one full rotation relative to the substrate and different portions of the first alignment layer are exposed to the polarized radiation through the aperture at different time instances.

## BRIEF DESCRIPTION OF THE DRAWINGS

The invention will be described in greater detail with reference to the accompanying drawings which represent preferred embodiments thereof and in which like reference labels are used to indicate like elements, wherein:

FIG. 1A is a prior art diagram illustrating a radially polarized beam;

FIG. 1B is a prior art diagram illustrating a tangentially polarized beam;

FIG. 2A is a schematic diagram showing a side view of a space-variant liquid crystal waveplate of the present invention;

FIG. 2B is a plane view of the space-variant liquid crystal waveplate of FIG. 2A having a tangential optic axis pattern;

FIG. 2C is a plane view of the space-variant liquid crystal waveplate of FIG. 2A having a radial optic axis pattern;

FIG. 3 illustrates examples of optic axis orientation patterns of the space-variant liquid crystal waveplate of the present invention;

FIG. 4A is a schematic side view of one embodiment of an optical exposure apparatus for inducing continuous space-variant alignment in an alignment layer of the space-variant liquid crystal waveplate;

FIG. 4B is a schematic diagram illustrating a lateral alignment of the waveplate substrate in the apparatus of FIG. 4A.

FIG. 5 is a diagram showing the exposure area on the alignment layer in the apparatus of FIG. 4A;

FIG. 6 is a schematic diagram of a vortex alignment pattern of the vortex order -1.5 formed in the alignment layer according to the method of the present invention;

FIG. 7 is a table summarizing an exemplary waveplate fabrication process according to one embodimetn of the present invention;

FIG. 8A is a schematic side view of a second embodiment of the optical exposure apparatus for inducing continuous space-variant alignment in an alignment layer of the space-variant liquid crystal waveplate;

FIG. 8B is a schematic diagram illustrating a lateral alignment of the waveplate substrate in the apparatus of FIG. 8A;

FIG. 9 is a flowchart illustrating general steps of the method of fabricating the space-variant liquid crystal waveplate of the present invention;

FIG. 10 is a schematic diagram illustrating a side view of another embodiment of the space-variant liquid crystal waveplate utilizing nematic LC;

FIG. 11 is a schematic diagram of a first optical system utilizing the space-variant liquid crystal waveplate;

FIG. 12 is a schematic diagram of a second optical system utilizing the space-variant liquid crystal waveplate;

FIG. 13 illustrates point spread functions obtained using the space-variant waveplates having vortex optic axis patterns of orders 1/2, 1 and 3/2.

## DETAILED DESCRIPTION

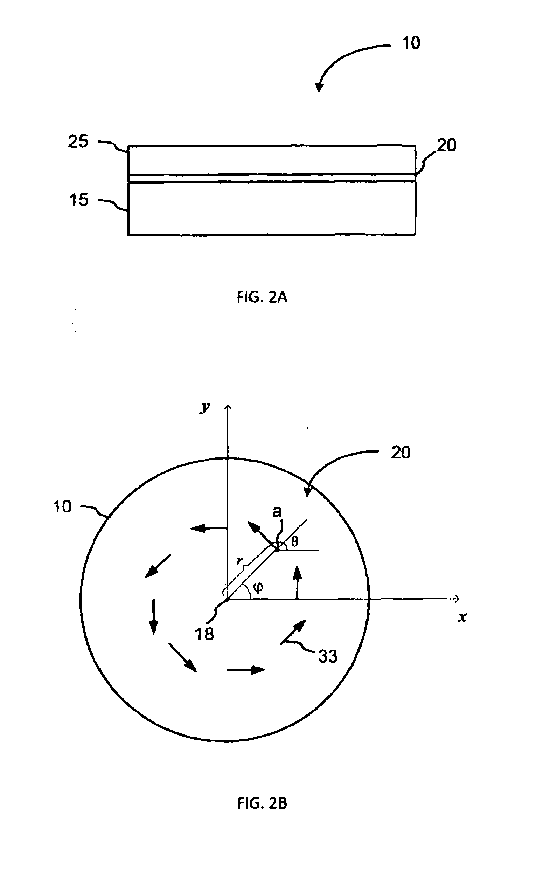

Turning first to FIG. 2A, the invention provides a method for fabricating a space-variant photo-aligned LC (SVLC) waveplate 10 that is capable of forming a polarization vortex beam of substantially any pre-defined vortex order *m*. In the embodiment illustrated in FIG. 2A the SVLC waveplate 10 utilizes an LC layer 25 of an LC material such as a liquid crystal polymer (LCP), which is disposed on an alignment layer 20 of a photo-alignable material, such as a linear photopolymerizable polymer (LPP), which is in turn disposed on a planar substrate 15. An example of an LPP is polyvinyl 4-methoxy-cinnamate ("PVMC"). A molecular orientation of the LPP is set by exposure to linearly polarized ultraviolet (LPUV) light to form an LC alignment pattern of the LC material that results in a desired spatial pattern of the optic axis (OA) of the waveplate layer 25. In the context of this specification, the words "spatial pattern of the optic axis" or "spatial OA pattern" are used to mean the dependence of the OA orientation on the azimuthal angle φ in a polar system of coordinates (r, φ) defined in a plane of interest, such the plane of the waveplate layer 20, for example its surface. The azimuthal variation of the optic axis (OA) of the SVLC waveplate 10 may be achieved by synchronous rotation of the LPUV exposure and its polarization relative to the alignment layer 20. After the LPUV exposure the LPP layer 20 is coated with the LCP to a specific thickness to obtain a desired retardance of the LCP film. The orientation of the LPUV light is varied during the formation of the alignment pattern in the LPP layer 20, and the orientation of the optic axis of the waveplate formed by the LCP film is defined by the photo-induced alignment pattern in the LPP layer.

The method of the present invention enables to fabricate photo-aligned waveplates having a space-variant OA that is uniquely defined at each location on the SVLC waveplate 10 by the following equation (2):

$$\theta = \alpha \times \varphi + \theta_0, \qquad (2)$$

In equation (2), φ is an azimuthal angle of the respective location in a polar system of coordinates (r, φ) that is associated with the waveplate, θ is an orientation angle defining the orientation of the optic axis (OA) at the location corresponding to the azimuth angle φ, α is an angular rate of change of the OA orientation with respect to the azimuth φ and $\theta_0$ is the OA orientation angle at locations corresponding to zero azimuth: φ = 0.

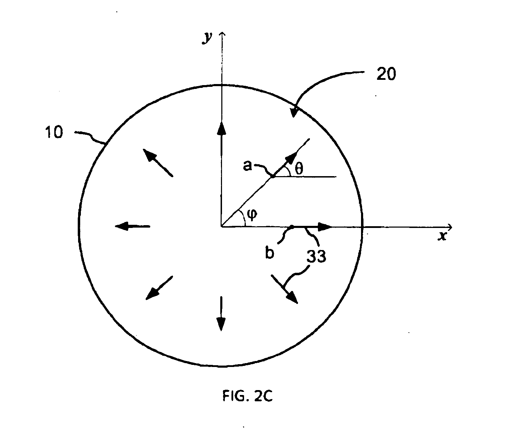

Two comparative examples of the space-variant waveplate 10 that correspond to α = 1 are illustrated in FIGs. 2B and 2C, which schematically show the SVLC waveplate 10 in a plane view, i.e. as seen from the waveplate layer 25. Arrows 33 illustrate the optic axis orientations at a few exemplary locations of the SVLC waveplate 10 at a distance *r* from its center 18. The waveplate of FIG. 2C has a radially-aligned OA corresponding to $\theta_0 = 0$, while the waveplate of FIG. 2B has a tangentially aligned OA corresponding to $\theta_0 = \pi/2$ radian. The angles φ and 9 are defined relative to the x-axis of a rectangular (x,y) coordinate system associated with the face of the waveplate, as illustrated in FIGs. 2B, C for a particular location 'a' on the waveplate. The x- and y-axes may be suitably defined in the plane of the SVLC waveplate 10, so that the (x,y) plane is parallel to the substrate/alignment layer interface.

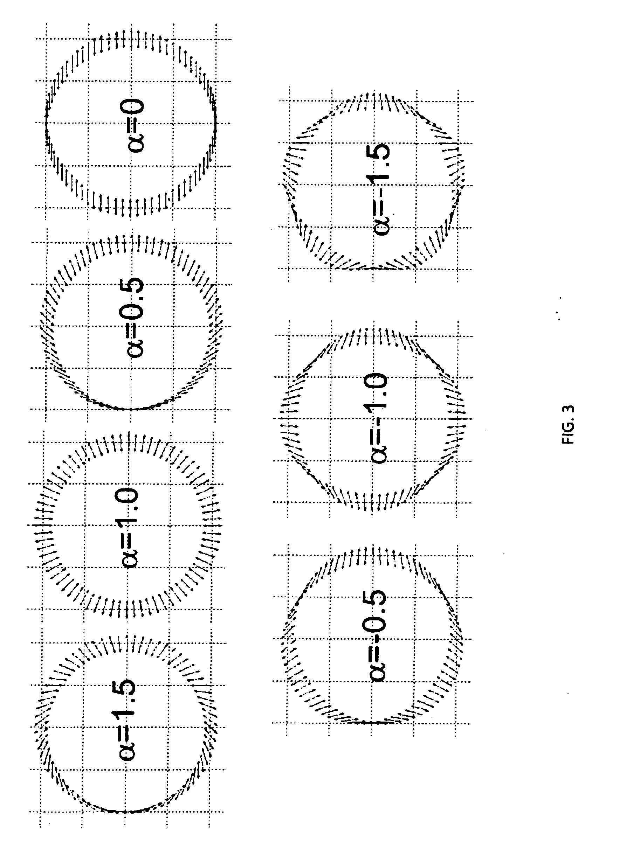

The OA orientation angle θ is continuous at all φ only when α = n/2, where *n* is an integer. In the context of this specification a two-dimensional orientation pattern that is defined by equation (2) with a = n/2 will be referred to as a vortex pattern of order n/2, with the coefficient α, or n/2, referred to as the vortex order of the pattern. A waveplate having a space-variant OA defined by equation (2) with α = n/2 is also referred to herein as a vortex waveplate of vortex order n/2, an n/2-vortex waveplate or simply as a vortex waveplate, with the coefficient α, or n/2 referred to as the vortex order of said waveplate. If a uniformly linearly polarized beam is passed through an n/2-vortex waveplate having a π retardance, a polarization vortex beam of an order *m = n* is formed. Examples of possible vortex orientation patterns of the OA of the SVLC waveplate 10 are shown in FIG. 3, wherein double-sided arrows indicate local OA orientation corresponding to vortex patterns of orders 1.5, 1.0, 0.5, 0, -0.5, -1.0, and -1.5.

In one embodiment, the method of the present invention utilizes an LPP material, such as ROLIC LPP ROP108/2CP available from *ROLIC Technologies,* to form the alignment layer 20; accordingly, in this embodiment the alignment layer 20 will also be referred to hereinbelow as the LPP layer 20. The substrate 15 is preferably of a material that is optically transparent in a wavelength range in which the SVLC waveplate 10 is to operate. By way of example, the SVLC waveplate 10 may be designed to operate in the range of 540~550nm, although other ranges of wavelengths could be equally selected. The selection of the operating wavelength range will define the required thickness of the LC layer as described hereinbelow. By way of example, the substrate 15 is a glass substrate, more particularly a 2" square of Coming 1737F glass, having a broadband anti-reflective (AR) coating on the back surface.

The substrate 15 may first be spin-coated with an optional adhesion promoter such as a suitable silane coupling agent. The alignment layer 20 is then formed by applying the LPP material over the adhesion promoter, or directly onto the substrate 15, for example in a liquid form by spin-coating or any other suitable method as would be known to those skilled in the art. The resulting structure, which will be generally referred to hereinbelow as the LPP coated substrate 15/20, is then subjected to thermal annealing, or bake, for several minutes at temperatures between 150 and 200 C, or as found suitable to evaporate the solvents and stabilize the LPP layer 20, or as appropriate. A typical thickness of the LPP layer 20 after the bake may be between 1 nm and 100 nm, for example 40 nm.

In a next step, the LPP coated substrate 15/20 is transferred into an optical exposure apparatus, wherein the alignment layer 20 is subject to the LPUV exposure to form a desired orientation pattern in the LPP layer 20.

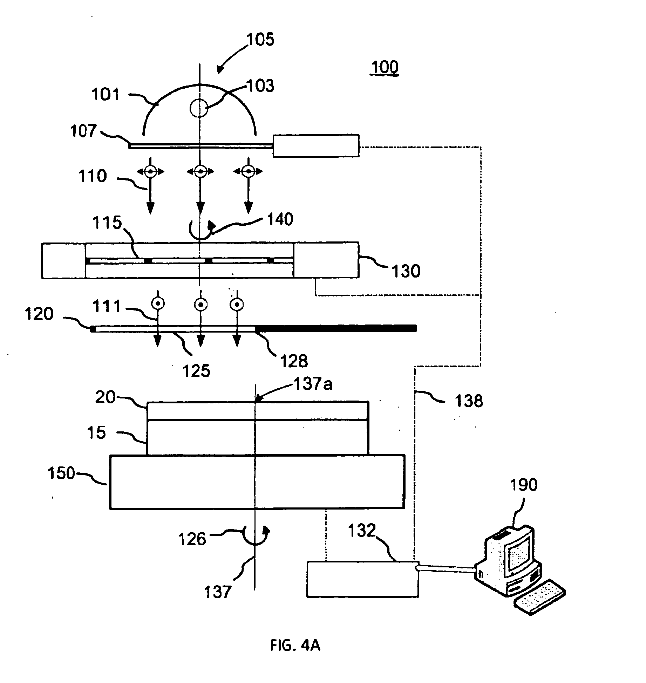

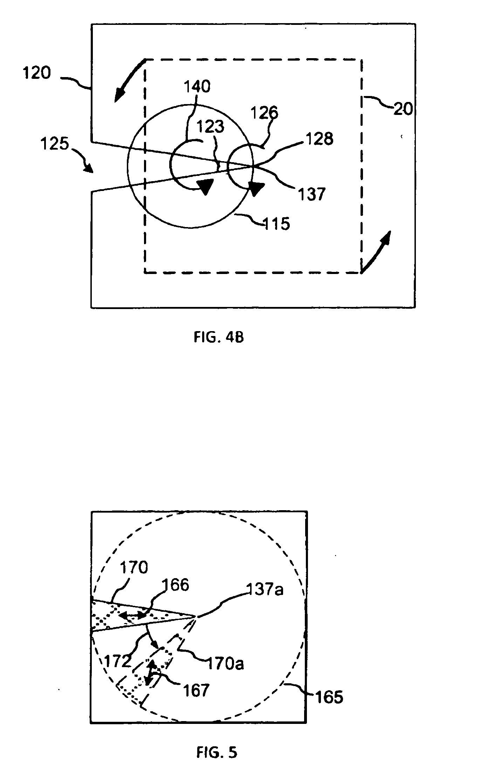

An example of the LPUV exposure apparatus is schematically shown in FIG. 4A, with FIG. 4B illustrating a lateral, i.e. in the plane of the SVLC waveplate 10, alignment of the LPP coated substrate 15/20 relative to the aperture 125 and the polarizer 115 within the apparatus 100.

Turning first to FIG. 4A, the LPUV exposure apparatus 100 includes a UV source 105 providing non-polarized UV light 110 at a wavelength in the range of 280 nm to 400 nm. This UV light 110 is passed through a polarizer 115, such as a Moxtek wire grid polarizer (WGP), which is mounted in a clear aperture of a first rotating stage 130, with LPUV light 111 exiting the polarizer 115. By way of example, the UV source 105 is shown to include a UV lamp 103, such as a 1kW Hg arc lamp, and an elliptical or parabolic reflector 101 for collecting the UV radiation of the UV lamp 103. UV LEDs, UV lasers, such as Argon lasers, fluorescent UV lamps, and fusion UV lamps are some of other possible options that can be used in the exposure system 100 in place of the UV source 105.

The substrate 15 coated with the alignment layer 20 is mounted on a second rotating stage 150 so as to expose a portion of the LPP alignment layer 20 to the linearly polarized UV light 111. Newport URM100PP, URS100BPP and URS 150BPP rotations stages, which include a stepper motor such as UE41PP and have 2" and 3.5" clear apertures, are non-exclusive examples of the first and second rotation stages that could be used in the exposure apparatus 100.

An aperture plate 120 with a clear aperture 125 is disposed in a stationary position next to the LPP alignment layer 20 in the optical path of the LPUV light 111. The aperture plate 120 is preferably mounted parallel to the substrate 15 and adjacent thereto, for example at a distance of 1 - 3 mm. FIG. 4B illustrates in a plane view the alignment of the LPP layer 20, the polarizer 115, and the wedge-shaped aperture 125 of the aperture plate 120. In a preferred embodiment the aperture 125, or at least a portion thereof adjacent to the alignment layer 20, is wedge-shaped, and has a vertex end 128 that in a plane view may be coincidental with a center point 137a of rotation of the alignment layer 20. By way of example the vertex angle of the wedge-shaped aperture is 5 degrees, but in other embodiments it may range between less than 1 degree to 90 degrees, preferably less than 10 degrees. The lower limit for suitable vertex angles may be defined, for example, by aperture manufacturing capabilities, brightness of the UV source, and the LPUV exposure time limitations,

The first and second rotation stages 130, 150 are electrically connected by control links 138 to a motion controller unit 132, which is in turn connected by a communication link to a processor unit 190. The motion controller unit 132 is programmed to control the rotations of the first and second rotation stages and to set their angular velocities according to parameters provided from the processor unit 190, including parameters setting initial positions of the substrate stage 150 and the polarizer stage 130, ending position or rotation angle of the substrate stage, rotation speed/direction of the substrate stage, ratio of the angular velocities of the polarizer stage to the substrate stage. In some embodiments, an optical shutter 107 may be provided in the optical path of the UV light 110 to control the start and end of the exposure process, in which case the opening or closing of this optical shutter 107 may be triggered by the controller 132 in response to control signals from the processor unit 190. By way of example, a Newport Universal Motion Controller ESP7000 may be used as the controller 132, and a general purpose computer may be used as the processor unit 190, with a USB link therebetween.

In operation, the substrate 15 with the LPP layer 20 is mounted on the second rotating stage 150 as described hereinabove, and the first and second rotation stages 130 and 150 are set to their initial positions. These initial positions of the rotating stages are selected so as to provide a desired initial orientation of the polarizer 115 relative to the LPP layer 20, which will define the value of the zero-azimuth OA orientation angle $\theta_0$ in equation (2).

Once the initial position of the polarizer 115 and the stages 130, 150 are set, the second rotation stage 150 performs one or more full rotations of the substrate 15 around a rotation axis 126 with a first angular velocity $\omega_1$. The LPUV radiation 111 from the UV source 105 irradiates a portion of the alignment layer 20 through the aperture 125, so as to form an exposure area radially extending from a center point 137a on the alignment layer 20. This is illustrated in FIG. 5, showing the irradiated surface of the alignment layer 20 and the exposure area 170 extending from the center point 128. Note that the center point 137a may or may not coincide with the geometrical center of the alignment layer 20. When illuminated by the polarized UV light, the LPP material selectively polymerizes in a direction parallel to the incident polarization, for example oriented as illustrated by a double-sided arrow 166. When the LC material of the waveplate layer 25 subsequently comes in a direct contact with the LPP layer 20, the LC material is aligned with the average LC director parallel to the direction of the polymer chains in the LPP later 20; this process may be assisted by heating the LCP to 50-55 °C. In other words, the LPUV exposure induces a molecular alignment pattern in the alignment layer 20 that is capable of anchoring molecules of the LC waveplate layer 25 thereby setting the local OA orientation of the resulting LC waveplate 10 parallel to the polarization of the LPUV light at the respective location during the LPUV exposure of the alignment layer 20. This process is known in the art as photo-induced LC alignment, and is used in LCD manufacturing and for manufacturing other photo-aligned polarization elements. Layer structures comprising an anisotropic film of LCPs in contact with an orientating layer of a linear photo-polymerised polymer network (LPP) are described for example in U.S. Pat. No. 5,602,661 (Schadt et al) and U.S. Pat. No. 5,389,689 (Chigrinov et al.). Suitable LPP materials are disclosed for instance in U. S. Patents 5,539,074, 6,201,087 and 6,107,427, and include cinnamic acid derivatives and ferulic acid derivatives. In the current invention, this process is utilized to form in the LPP layer 20 vortex alignment patterns of generally any pre-defined vortex order, and then to transfer this pattern into a substantially identical vortex OA orientation pattern in the LC waveplate layer 25, thereby forming a vortex waveplate of the pre-defined vortex order.

As the LPP coated substrate 15/20 rotates relative to the aperture 125, or in other embodiments the aperture 125 rotates relative to the substrate 15/20, the exposure area 170 also rotates about the central point 137a, as schematically shown by a curved arrow 172, and at a later time instance the exposure area moves to a different portion of the alignment layer 20, and may be as indicated at 170a. Once the exposure area 170 performs one full rotation about the center point 137a, a disk-shaped area 165 has been exposed to the LPUV radiation 111, with different portions of it at different time instances. At this point the UV lamp 105 may be turned off so that the exposure process stops, or it may continue until a desired radiation dose is reached.

Depending on the intensity of the UV radiation, two or more full rotations of the rotation stage 150, and therefore of the exposure area 170, may be performed to obtain a radiation dose that is suitable for the LPP alignment. Optionally, the controller 132 may trigger the UV lamp shutter 107 to open at the beginning of the exposure process, and to close at the end of the exposure process. To ensure a uniform exposure of the LPP layer 20, the vertex end 128 of the wedge-shaped aperture 125 is preferably positioned on the rotation axis 137 of the second rotation stage 150 about which the LPP-coated substrate 15/20 is rotated, with the center point 137a corresponding to the intersection of the rotation axis 137 with the exposed surface of the alignment layer 20. To facilitate accurate adjustment of the aperture vertex location relative to the substrate rotation axis, the aperture plate 120 may be mounted on an x-y micrometer stage (not shown).

By way of example, an aperture angle 123 of the aperture 125 is 5 degrees, the angular velocity $\omega_1$ of the substrate rotation is 0.2 rpm, and the exposure process lasts 300 sec which corresponds to one full rotation of the LPP coated substrate 15/20, thereby equally exposing all azimuthal locations of the LPP layer 20 to the LPUV radiation 111. Using a 1kW Hg arc lamp that emits in the wavelength range of 300 - 340 and provides an exposure area of about 100 mm in diameter, each exposed location of the LPP layer 20 receives a dose of UV radiation of about 40 mJ/cm$^2$ in the 300 - 340 nm spectral wavelength range, which we found suitable for inducing the required alignment in the LPP layer. A more intense UV radiation or a slower rotation of the substrate will provide a higher UV dose if required for a particular photo-alignable material of the alignment layer 20.

Simultaneously with the rotation of the substrate by second rotation stage 150, the polarizer 115 can also be rotated with a second angular velocity $\omega_2$. As a result, the UV polarization direction at the exposure area 170 will generally differ from the UV polarization direction at the exposure area 170, as illustrated in FIG. 5 by double-sided arrows 166 and 167, and therefore different LPP material alignment orientations will be photo-induced in those areas. By selecting the second angular velocity $\omega_2$ so as to be in a pre-determined ratio R to the first angular velocity, i.e. so as to satisfy the following equation (3):

$$\omega_2 = R \cdot \omega_1 \quad , \qquad (3)$$

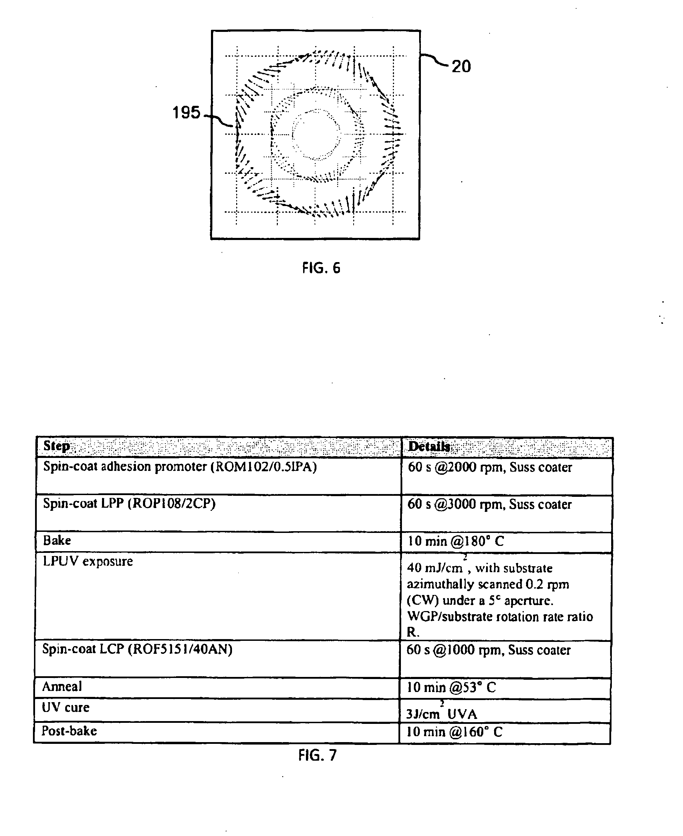

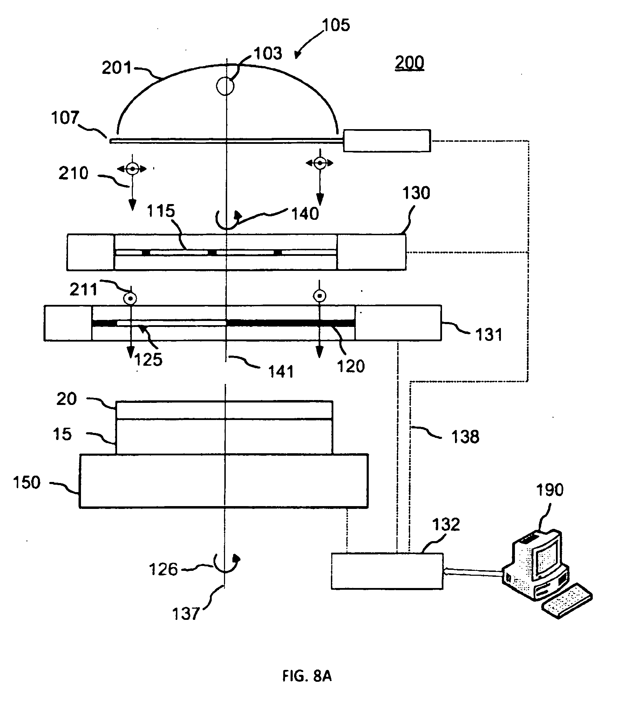

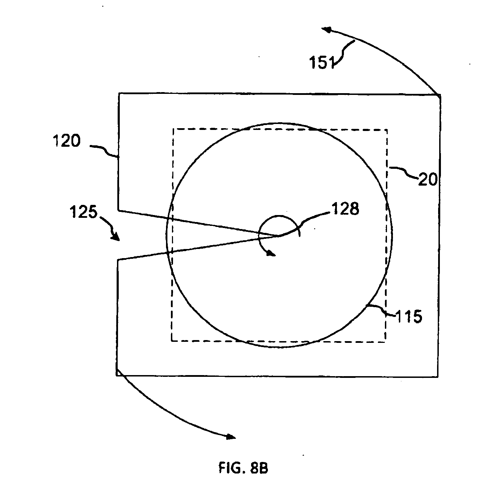

a pre-defined space-variant alignment pattern can be induced in the alignment layer 20 by the LPUV radiation. By selecting an angular velocity ratio

$$R = 1 - n/2, \qquad (4)$$

where $n$ is an integer, an alignment pattern required for the manufacturing of an n/2-vortex waveplate is produced in the LPP layer 20. Note that positive R corresponds to rotations in the same direction, while negative values of R correspond to rotating the substrate and the polarizer in opposite directions. Advantageously, vortex alignment patterns provided by the aforedescribed LPUV exposure process, as well as by the processed described hereinbelow with reference to FIGs. 8A ,B, is substantially continuous, i.e. spatially smooth without abrupt transitions in the OA orientation. FIG. 6 illustrates by way of example a vortex alignment pattern 195 formed in the alignment layer 20 by the aforedescribed process with the ratio of the angular velocities R = 2.5, i.e. by rotating the polarizer 115 2.5 times faster than the substrate stage 150.

Once the space-variant alignment pattern is photo-induced in the LPP layer 20 by the aforedescribed UV exposure process, the substrate 15 with the LPP alignment layer 20 is taken out of the exposure apparatus 100, and a suitable LCP precursor material is spin-coated, or in other applicable way deposited, coated or printed over the LPP alignment layer 20. The LPP layer 20 aligns the LCP precursor material, and herewith its optic axis, according to the space-variant alignment pattern that was induced in the LPP layer 20 by the exposure to the LPUV light in the apparatus 100. The resulting structure may first be annealed at an elevated temperature, and then the LCP precursor layer is cured by exposure to non-polarized UV light of suitable wavelength to be cross-linked, causing the LPP precursor material to polymerize into LCP and form the LC waveplate layer 25 shown in FIG. 2A. A post-bake step finalizes the process. An example of suitable LCP material is ROF-5151 LCP, available from *ROLIC Technologies.* An exemplary fabrication process of the space-variant photo-aligned waveplate of the present invention is summarized in a table in FIG. 7.

The thickness $d$ of the LC layer 25 depends on the amount of the LCP precursor material coated on the LPP layer 20, and is selected so as to provide a desired retardance Γ of the SVLC waveplate 10 at an operating wavelength of interest λ according to the following equation (5):

$$d = (\lambda/\Delta n)(N + \Gamma/2\pi) \qquad (5)$$

where Δn is the birefringence, i.e. the difference between the ordinary and extraordinary indices of the LC waveplate layer 25 at the wavelength λ, and $N$ is a non-negative integer known as the waveplate order. The LC layer thickness of a zero-order half-wave plate is then d = λ/Δn (N+1/2). For the exemplary LCP material used, Δn is approximately 0.103 at λ=550nm; so that the physical thickness of the waveplate layer 25 is approximately 2.7 micrometers for 275nm retardance at the operating wavelength λ=550nm.

The aforedescribed fabrication process produces a photo-induced space-variant LC waveplate. In a preferred embodiment, the controller 132, either alone or in cooperation with the processor 128, is programmed to control the first and second rotation stages 130, 150 so that the ratio R =$\omega_1/\omega_2$ of the first and second angular velocities is maintained at a pre-determined value. It is further preferred that this ratio is controlled so that

$$R = (1 - n/2), \qquad (6)$$

where $n$ may be any integer as needed for a particular waveplate, and may be 0, positive or negative. If condition (6) is satisfied, the SVLC waveplate 10 produced by the aforedescribed exposure process is an $n/2$-vortex waveplate. Note that selecting $n$ =0 corresponds to rotating the polarizer 115 and the LPP coated substrate 15/20 in the same direction at equal angular velocities, and results in a unidirectional OA orientation of the produced waveplate.

If the polarizer 115 remains stationary during the UV exposure, i.e. R = 0 and n = 2, both the alignment pattern induced in the LPP layer 20, and the OA orientation pattern are circularly symmetric, such as those shown in FIGs. 2B and 2C, and are suitable for producing second-order polarization vortex beams. Advantageously, by simultaneously rotating both the polarizer 115 and the LPP coated substrate 15/20, space-variant vortex waveplates of the order $n/2$ with n other than 2 can be fabricated.

The aforedescribed optical exposure apparatus 100 utilizes UV exposure of the LPP alignment layer 20 through a stationary narrow wedge-shaped aperture while simultaneously rotating both the LPP alignment layer 20 and the polarization of the UV light 111 incident thereupon; as a result, different portions of the alignment layer are exposed to the polarized UV light at different time instances, with the polarization orientation of the LPUV exposure at a particular azimuthal location depending on the ratio R of the respective angular velocities. The following table 1 illustrates by way of examples the correspondence between the ratio R of the angular velocities, the vortex order of the resulting waveplate a = dθ/dφ, and the vortex order m of a polarization vortex beam that may be obtained from a uniformly polarized beam by passing through the resulting space-variant waveplate.

Table 1

| R | α | m |
|------|-----|---|
| -0.5 | 1.5 | 3 |
| 0 | 1.0 | 2 |
| +0.5 | 0.5 | 1 |

(continued)

| R | $\alpha$ | m |
|---|---|---|
| +1.0 | 0 | 0 |
| +1.5 | -0.5 | -1 |
| +2.0 | -1.0 | -2 |
| +2.5 | -1.5 | -3 |

Keeping the aperture 115 stationary during a LPUV exposure process is not a necessary requirement in the current invention. We found that the space-variant vortex alignment patterns of an arbitrary vortex order can be produced in an exposure apparatus similar to the apparatus 100 by rotating, at selected angular velocities, any two of the first alignment layer 20, the aperture 115 and the polarization orientation of the LPUV radiation 111. Accordingly, other embodiments of the LPUV exposure apparatus may include means for rotating the aperture while one of the substrate 15 and the polarizer 115 is held stationary, or when all three of the polarizer 115, the aperture 125 and the substrate 15 are rotated during the LPUV exposure at selected relative angular velocities.

A second example 200 of the LPUV exposure apparatus is shown FIG. 8A. Similarly to FIG. 4B, FIG. 8B illustrates in a plane view instantaneous relative positions of the alignment layer 20, the polarizer 115 and the aperture plate 120, when seen from the UV source 105 in FIG. 8A. Note that for clarity of the description like elements are labeled in FIGs. 4A, 4B, and 8A and 8B with like reference numerals. One difference between the exposure apparatuses 100 and 200 is that in the apparatus 200 the aperture plate 120 is mounted within a clear aperture of a third rotation stage 131, also referred to as the aperture stage 131. In operation, the aperture stage 131 is controlled by the motion controller 132, so that the wedge-shaped aperture 125 is rotated about a rotation axis 141 during the exposure process at a third angular velocity $\omega_3$; this rotation is illustrated with a curved arrow 151 in FIG. 8B.

Since the aperture 115 is now rotated during the LPUV exposure process, the UV radiation 210 from the UV source 105 has to be present at any azimuthal position of the aperture 25 with respect to the alignment layer 20. In the shown in FIG. 8A embodiment this is ensured by a comparatively larger diameter of a collimated UV beam 210 emitted by a UV source 205 relative to the UV beam 110 of the UV source 105 of the apparatus 100 of FIG. 4A. Alternatively, the UV source 205 with the polarizer 115 could be mounted on the aperture rotation stage 131 at a fixed position relative to the aperture 125 so that the aperture is constantly irradiated during the rotation. In other examples, a beam scanning technique synchronous with the aperture rotation may be implemented.

One embodiment of the LPUV exposure process may include exposing different portions of the alignment layer 20 in the exposure apparatus 200 by rotating the aperture 125 while keeping the substrate 15, and therefore the LPP layer 20, stationary. If the polarizer 115 is also kept stationary during the exposure process, one full rotation of the aperture 125 results in the formation of a circularly-symmetric alignment pattern in the LPP layer 20, provided that the LPUV power, the angular velocity of the aperture and the aperture angle area selected so that a suitable UV dose is received by the LPP layer; if a single revolution of the aperture provides insufficient dose of the LPUV radiation, multiple revolutions of the aperture may be performed as required.

Alignment patterns that do not have a full circular symmetry may be produced by rotating either the polarizer 115 or the substrate 15 simultaneously with rotating the aperture 115. In one embodiment of the method, the LPUV exposure process includes performing at least one full rotation of the aperture 115 about its vertex end 128 at a third angular velocity $\omega_3$ so as to expose different portions of the first alignment layer to the polarized radiation through the aperture at different time instances, while rotating the polarization orientation of the LPUV radiation 211 by rotating the polarizer 115 at a forth angular velocity $\omega_4$ that satisfies the following condition:

$$\omega_4 = (n/2 - 1) \cdot \omega_3, \qquad (7)$$

wherein n is an integer. In this embodiment of the method, the substrate is kept stationary, and the second rotation stage 150 is therefore optional and may be substituted with a substrate holder. When an LC waveplate layer 25 is subsequently formed on top of the alignment layer 20, the OA of the LC waveplate layer 25 is anchored by the alignment pattern induced by the LPUV exposure in the LPP layer 20, so that the resulting structure is an *n*/2-vortex waveplate, i.e. is characterized by a space-variant OA pattern that satisfies equation (2) with $\alpha$ = n/2.

In another embodiment, the LPUV exposure process using the exposure apparatus 200 includes rotating the aperture 125 at a fifth angular velocity $\omega_5$, while keeping the polarizer 115, and thus the polarization orientation of the polarized UV radiation 211 stationary and rotating the substrate 15 at a sixth angular velocity $\omega_6$ that satisfies the following

condition:

$$\omega_6 = (1-2/n) \cdot \omega_5, \qquad (8)$$

wherein n is an integer. In this embodiment, the substrate and the aperture are rotated until the aperture 125 performs at least one full rotation relative to the substrate, i.e. the exposure area 170 shown in FIG. 5 performs a full rotation about the center point 137a, so that all azimuthal locations of the alignment layer 20 are exposed to the LPUV radiation, with different portions of the first alignment layer 20 being exposed at different time instances. Since the polarizer 115 is kept stationary, the first rotation stage 130 is therefore optional in this embodiment.

As one skilled in the art would appreciate, the embodiments 100 and 200 of the optical exposure system of the present invention are described herein by way of example only, with FIGs. 4A,B and 8A,B being schematic representations thereof showing those elements that are required for understanding and practicing the invention. Those skilled in the art would be able to modify the shown embodiments according to their particular requirements, and many such modifications are possible within the scope of the invention. For example, the optical exposure systems 100 and 200 described hereinabove utilize a combination of a UV source 105 of non-polarized radiation such as an arc lamp, and a polarizer 115. However, a source of linearly polarized UV radiation such as a UV laser can be used instead, so that the polarizer 115 may not be required; in that case, the polarization orientation of the LPUV radiation may be rotated by rotating the source itself, or using a polarization rotator in place of the polarizer 115. Furthermore, the arc lamps 105 and 205 are shown in FIGs. 4A and 8A only schematically, and may include additional elements such as UV mirrors, homogenizer (integrator), aperture, collimating optics, power supply, shutter timer, etc.

Although in the aforedescribed embodiments the vortex alignment patterns are produced by rotating two of the aperture, the substrate and the polarizer and keeping the third of said elements stationary, it would also be possible to produce the desired vortex alignment patterns in the alignment layer 20 by rotating all three of them simultaneously, with the angular velocities ratios selected so as to induce an alignment pattern that satisfies equation (2). Next, although in the shown embodiments the LPUV light impinges upon the alignment layer 20 at 90 degrees, in other embodiments the angle of incidence of the LPUV light upon the alignment layer 20 may differ from 90 degrees, for example if a O-plate retardance, or a C-plate retardance component, is desired in the SVLC waveplate 10. In the case of producing O-plate retardance, the LPP and LC materials of suitable for producing such retarances should be selected for the alignment layer 20 and the waveplate layer 25. O-plate LC materials generally have their OA tilted at an angle with respect to the substrate surface, thereby giving rise to in-plane (A-plate) and out-of-plane (C-plate) retardance components.

As stated hereinabove, in a preferred embodiment the aperture 125 has a shape of a wedge with a vortex end positioned on an axis 141 of rotation of the aperture if the aperture is rotated in the LPUV exposure process, or on an axis 137 of rotation of the alignment layer 10 if the alignment layer 10 is rotated in the LPUV exposure process. Although the wedge shape of the aperture 125 is preferred, other aperture shapes may potentially also be used, such as a narrow slit with a width that is much smaller than the slit length, with one end of the slit positioned at or close to an axis of relative rotation of the aperture and the substrate. Such an aperture would however produce an alignment pattern that deviates from a true vortex pattern as defined by equation (2), with the deviations being relatively larger at the vortex center and the greater the wider is the slit.

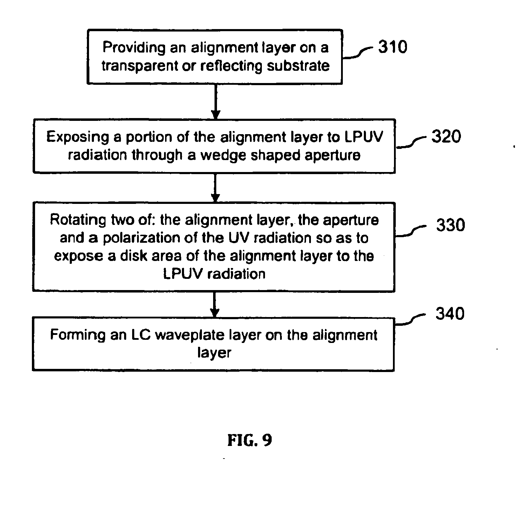

With reference to FIG. 9, the method of the present invention for fabrication of a space-variant waveplate such as the SVLC waveplate 10 includes the following general steps:

In a first step 310, an alignment layer 20 of a photo-alignable material is provided on a substrate 15. The substrate 15 is preferably optically transparent at least in a target operating wavelength range of the waveplate if the resulting waveplate is to operate in transmission, but in other embodiments can also be optically reflective is the resulting waveplate is to operate in reflection.

In a following step 320, a portion of the alignment layer 20 is irradiated through an aperture 125 by LPUV radiation so as to form an exposure area 170 radially extending from a center point on the alignment layer 20, the LPUV radiation having a wavelength and intensity suitable for inducing an alignment within the alignment layer 20.

In a step 330, at least two of the alignment layer 20, the aperture 125 and a polarization of the LPUV radiation are rotated while continuously exposing portions of the alignment layer 20 to the LPUV radiation through the aperture, so that the exposure area 170 performs at least one rotation about the center point and a disk-shaped area 165 of the alignment layer 20 has been exposed to the LPUV radiation. In preferred embodiments, the rotations are performed at angular velocities which ratio is set according to equations (4), (7) or (8) so as to induce a vortex alignment pattern within the alignment layer 20.

In a next step 340, the waveplate layer 25 of an LC material is formed on the alignment layer such that the liquid crystal material is aligned according to the photo-induced vortex alignment pattern within the alignment layer 20.

In the embodiments described hereinbefore wherein the LC material of the waveplate layer is an LCP, step 340 may complete the fabrication of the space-variant waveplate 10 of the present invention.

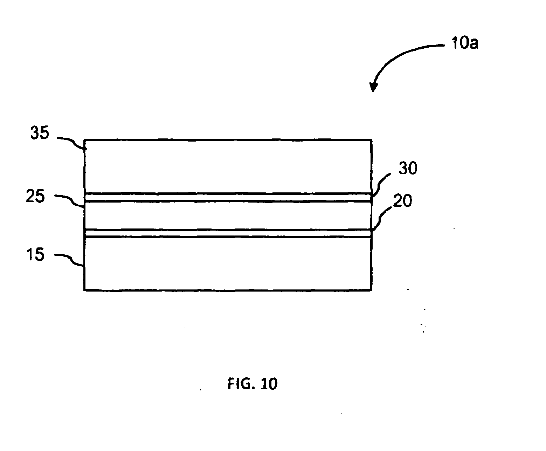

However, non-polymer LC materials, such as those used in LCD industry, may also be utilized for the waveplate layer 25, with a suitable photo-alignable material used for the alignment layer 20. For example, in one such alternative embodiment the waveplate layer 25 is formed of a nematic LC or a twisted nematic (TN) LC material, and is interposed between the first alignment layer 20 and a second alignment layer 30 that is formed on a second substrate 35, resulting in a SVLC waveplate 10a schematically illustrated in FIG. 10. Accordingly, step 340 of forming the waveplate layer 25 may in this embodiment include providing the LC material into a cavity formed between the first alignment layer 20 and the second alignment layer 30. The second and first alignment layers may have substantially identical alignment patterns such as those described hereinabove. Alternatively, the second alignment layer 30 may have a unidirectional alignment pattern, resulting in a uniform orientation of LC molecules of the waveplate layer 25 bordering the second alignment layer 30.

Note also that photo-alignable materials other than LPP, with one example being polyimides, are known in the art to be useful for aligning LC molecules in LC devices, and these materials may also be used in the present invention to form the alignment layer 20.

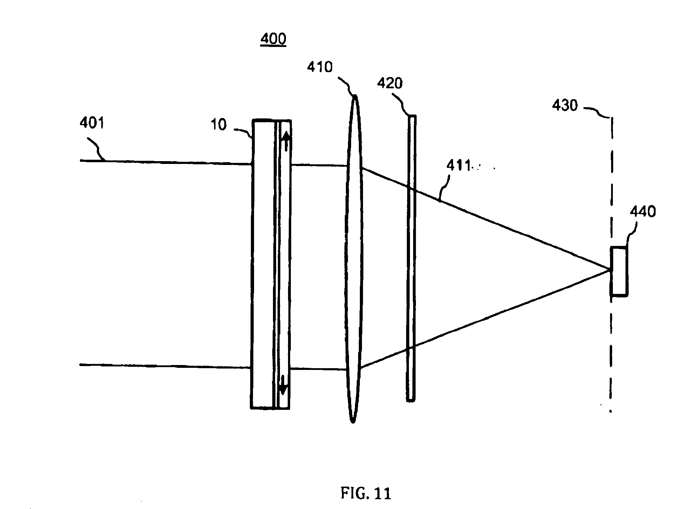

Turning now to FIG. 11, a simple optical system 400 utilizing the space-variant waveplate 10 produced according to the method of the present invention is shown by way of example. In this system, the space-variant waveplate 10 is disposed in an optical path of a collimated beam 401 of linearly polarized radiation, converting it into a polarization vortex beam. It is followed by a collimating lens 410, which may in turn be followed by a polarizer 420; a converging beam 411 1 linearly polarized is formed at the output of the. A screen 430 or a camera 440 may be positioned at a focal distance from the lens 420 so that a point spread function (PSF) of the optical system 400 can be visualized; herein the PSF is understood as an optical intensity distribution in the focal plane of an optical system given a point source object.

Advantageously, the combination of the space-variant waveplate 10 and the polarizer 420 adds a space-variant Pancharatnam-Berry phase to the beam 401, and enables to shape the PSF of the system 400 in a way that would be difficult to achieve otherwise.

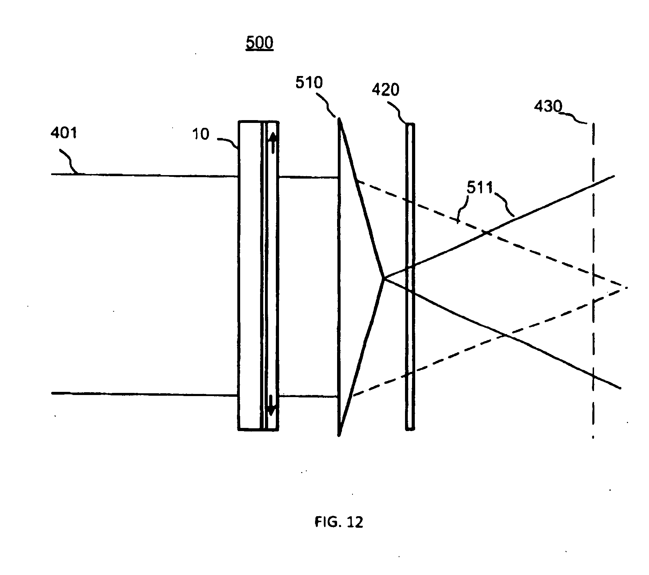

The collimating lens 410 in the optical system 400 may be replaced by an axicon lens 510, resulting in a system 500 illustrated in FIG. 12. This system converts the linearly polarized beam 410 into a Bessel beam 511, i.e. a beam which intensity profile in the beam cross-section may be described by a Bessel function. This beam is known to be non-diffracting, i.e. the beam's intensity profile is invariant as the beam propagates. This feature of the beam 511 may be advantageously used for optical trapping of particles, i.e. the beam 511 can be used as optical tweezers.

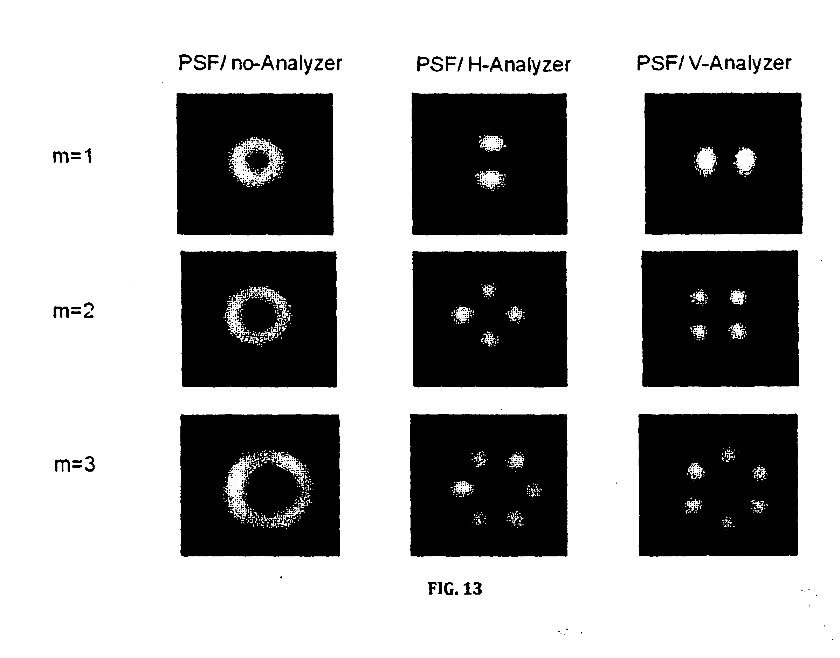

FIG. 13 shows by way of example nine PSFs obtained using three different space-variant waveplates in the optical system 400. Top raw images correspond to a polarization vortex beam of the first order, m = 1, produced using the space-variant LC waveplate 10 of the vortex order 0.5, images in the middle raw correspond to a polarization vortex beam of the second order, m = 2, produced using the space-variant LC waveplate 10 of the first vortex order; and images in the bottom raw correspond to a polarization vortex beam of the third order, m = 3, produced using the space-variant LC waveplate 10 of the vortex order 1.5. Left, middle and right columns illustrate the effect of the polarizer 420 and correspond to no polarizer, a horizontal polarizer orientation and a vertical polarizer orientation, respectively.

This figure also qualitatively illustrates intensity profiles of the Bessel beams obtained when using the respective waveplates in the system 500. When such beams are used as optical tweezers, particles can be trapped in the dark areas between the bright high-intensity spots visible in the images in the lower-left portion of FIG. 13 and manipulated by rotating the polarizer 420, with higher-order vortex beams enabling to simultaneously trap and manipulate a larger number of particles. Advantageously, the method of the present invention enables to provide space-variant waveplates of an arbitrary vortex order, so that a polarization vortex beam of a high vortex order m ≥ 3 can be produced using a single such waveplate.

Note that the particular embodiments of the present invention described hereinabove are by way of example only, and alternative embodiments of many elements and steps can be employed in particular applications of the invention as would be evident for those skilled in the art.

Of course numerous other embodiments may be envisioned without departing from the scope of the appended claims.

**Claims**

1. A method of fabricating a space-variant wave plate (10, 10a) comprising the steps of:

   a) providing a first alignment layer (20) of a photo-alignable material on a substrate (15) that is substantially transparent or reflective to optical radiation in an operating wavelength range;
   b) irradiating a portion of the first alignment layer (20) with polarized radiation through an aperture (125) so as to form an exposure area (170, 170a) radially extending from a center point (137a) on the alignment layer (20) and to provide a spatially varying alignment of the photo-alignable material, the polarized radiation having a wavelength suitable for inducing alignment in the alignment layer (20); and,
c) forming a waveplate layer (25) of a liquid crystal material on the first alignment layer (20) so that the waveplate layer (25) has an optic axis (33) which varies in a plane of the waveplate layer according to the spatially varying alignment;

**characterized in that**
step b) includes rotating at least two of the first alignment layer, the aperture and a polarization orientation of the polarized radiation at selected angular velocities so that the exposure area performs at least one rotation about the center point,
wherein a ratio of said angular velocities is selected for forming in the alignment layer a vortex alignment pattern (195) of a selected vortex order $\alpha = m/2$ with respect to azimuthal locations on the alignment layer (20), wherein *m* is a non-zero integer not equal to 2, for providing in step (c) a vortex pattern of the selected vortex order $\alpha \neq 1$ for the optic axis of the waveplate layer (25).

2. A method of claim 1, wherein step (b) comprises performing at least one rotation of the substrate (15) at a first angular velocity $\omega_1$ so as to expose different portions of the first alignment layer (20) to the polarized radiation through the aperture (125) at different time instances, while rotating the polarization orientation of the polarized radiation at a second *angular velocity* $\omega_2$ that is equal to (**1-*m*/2**)$\cdot\omega_1$, and while keeping the aperture (125) stationary with an end of the aperture positioned on an axis of rotation of the substrate (15).

3. A method of claim 1, wherein step (b) comprises performing at least one rotation of the aperture (125) about an end (128) thereof at a third angular velocity $\omega_3$ so as to expose different portions of the first alignment layer (20) to the polarized radiation through the aperture (125) at different time instances, while rotating the polarization orientation of the polarized radiation at a forth angular velocity $\omega_4$ that is equal to (m/2-1)$\cdot\omega_3$.

4. A method of claim 1, wherein step (b) comprises rotating the aperture (125) at a fifth angular velocity $\omega_5$, while keeping the polarization orientation of the polarized radiation stationary and rotating the substrate (15) at a sixth angular velocity $\omega_6$ that is equal to (1-2/m)$\cdot\omega_5$, so that the aperture (125) performs at least one full rotation relative to the substrate (15) about the center point (137a) and different portions of the first alignment layer (20) are exposed to the polarized radiation through the aperture (125) at different time instances.

5. A method of any one of claims 2, 3 and 4, wherein the aperture (125) has a wedge-shaped portion with a vertex end, and wherein the vertex end is positioned on an axis (137) of rotation of the aperture (125) if the aperture is rotated in step (b), or on an axis of rotation of the substrate (15) if the substrate is rotated in step (b).

6. A method of claim 2 or claim 3, wherein step (b) comprises forming the polarized radiation by passing UV radiation through a polarizer (115), and further comprising rotating the polarizer (115).

7. A method of any one of claim 1 to 4, wherein the photo-alignable material comprises linear photo-polymerizable polymer (LPP), and the polarized radiation is linearly polarized UV light.

8. A method of any one of claims 1 to 4, wherein the LC material comprises LC polymer, and wherein step (c) comprises the steps of:

   depositing an LCP precursor material on the alignment layer (20); and,
   polymerizing the LCP precursor material by exposure thereof to UV light to form the waveplate layer (25).

9. A method of claim any one of claims 1 to 4 wherein the LC material comprises a nematic LC.

10. A method of claim 9, wherein step (c) comprises providing a second alignment layer (30), so that the waveplate layer (25) is interposed between the first (20) and second (30) alignment layers.

11. A method of claim 10, wherein the nematic LC comprises twisted nematic LC, and wherein the second alignment layer (30) is **characterized by** a unidirectional alignment orientation that does not vary in a plane of the second alignment layer.

**Patentansprüche**

1. Ein Verfahren zum Herstellen einer räumlich veränderlichen Verzögerungsplatte (10, 10a), das die folgenden Schritte beinhaltet:

    a) Bereitstellen einer ersten Ausrichtungsschicht (20) aus einem photoausrichtbaren Material auf einem Substrat (15), das im Wesentlichen für optische Strahlung in einem Betriebswellenlängenbereich transparent oder reflektierend ist;
    b) Bestrahlen eines Abschnitts der ersten Ausrichtungsschicht (20) mit polarisierter Strahlung durch eine Blende (125), um einen Belichtungsbereich (170, 170a) zu bilden, der sich radial von einem Mittelpunkt (137a) auf der Ausrichtungsschicht (20) erstreckt, und um eine räumlich veränderliche Ausrichtung des photoausrichtbaren Materials bereitzustellen, wobei die polarisierte Strahlung eine zum Herbeiführen von Ausrichtung in der Ausrichtungsschicht (20) geeignete Wellenlänge aufweist; und,
    c) Bilden einer Verzögerungsplattenschicht (25) aus einem Flüssigkristallmaterial auf der ersten Ausrichtungsschicht (20), so dass die Verzögerungsplattenschicht (25) eine optische Achse (33) aufweist, die sich gemäß der räumlich veränderlichen Ausrichtung in einer Ebene der Verzögerungsplattenschicht ändert;

    **dadurch gekennzeichnet, dass**
    Schritt b) das Drehen von mindestens zweien der ersten Ausrichtungsschicht, der Blende und einer Polarisierungsorientierung der polarisierten Strahlung mit ausgewählten Winkelgeschwindigkeiten umfasst, so dass der Belichtungsbereich mindestens eine Drehung um den Mittelpunkt ausführt,
    wobei ein Verhältnis der Winkelgeschwindigkeiten dazu ausgewählt wird, in der Ausrichtungsschicht ein Wirbelausrichtungsmuster (195) einer ausgewählten Wirbelordnung $\alpha = m/2$ in Bezug auf azimutale Orte auf der Ausrichtungsschicht (20) zu bilden, wobei $m$ eine von Null verschiedene ganze Zahl ungleich 2 ist, um in Schritt (c) ein Wirbelmuster der ausgewählten Wirbelordnung $\alpha \neq 1$ für die optische Achse der Verzögerungsplattenschicht (25) bereitzustellen.

2. Verfahren gemäß Anspruch 1, wobei Schritt (b) das Ausführen von mindestens einer Drehung des Substrats (15) mit einer ersten Winkelgeschwindigkeit $\omega_1$ beinhaltet, um verschiedene Abschnitte der ersten Ausrichtungsschicht (20) zu verschiedenen Zeitinstanzen an die polarisierte Strahlung durch die Blende (125) auszusetzen, während die Polarisierungsorientierung der polarisierten Strahlung mit einer zweiten *Winkelgeschwindigkeit* $\omega_2$ gedreht wird, die gleich $(1\text{-}m/2)\cdot\omega_1$ ist, und während die Blende (125), mit einem Ende der Blende auf einer Drehungsachse des Substrats (15) positioniert, stationär gehalten wird.

3. Verfahren gemäß Anspruch 1, wobei Schritt (b) das Ausführen von mindestens einer Drehung der Blende (125) um ein Ende (128) derselben mit einer dritten Winkelgeschwindigkeit $\omega_3$ beinhaltet, um verschiedene Abschnitte der ersten Ausrichtungsschicht (20) zu verschiedenen Zeitinstanzen an die polarisierte Strahlung durch die Blende (125) auszusetzen, während die Polarisierungsorientierung der polarisierten Strahlung mit einer vierten Winkelgeschwindigkeit $\omega_4$ gedreht wird, die gleich $(m/2\text{-}1)\cdot\omega_3$ ist.

4. Verfahren gemäß Anspruch 1, wobei Schritt (b) das Drehen der Blende (125) mit einer fünften Winkelgeschwindigkeit $\omega_5$ beinhaltet, während die Polarisierungsorientierung der polarisierten Strahlung stationär gehalten wird und das Substrat (15) mit einer sechsten Winkelgeschwindigkeit $\omega_6$ gedreht wird, die gleich $(1\text{-}2/m)\cdot\omega_5$ ist, so dass die Blende (125) mindestens eine volle Drehung relativ zu dem Substrat (15) um den Mittelpunkt (137a) ausführt und verschiedene Abschnitte der ersten Ausrichtungsschicht (20) zu verschiedenen Zeitinstanzen an die polarisierte Strahlung durch die Blende (125) ausgesetzt werden.

5. Verfahren gemäß einem der Ansprüche 2, 3 und 4, wobei die Blende (125) einen keilförmigen Abschnitt mit einem Scheitelpunktende aufweist, und wobei das Scheitelpunktende auf einer Drehungsachse (137) der Blende (125) positioniert ist, wenn die Blende in Schritt (b) gedreht wird oder auf einer Drehungsachse des Substrats (15) positioniert ist, wenn das Substrat in Schritt (b) gedreht wird.

6. Verfahren gemäß Anspruch 2 oder Anspruch 3, wobei Schritt (b) das Bilden der polarisierten Strahlung durch Leiten von UV-Strahlung durch einen Polarisator (115) beinhaltet und weiter das Drehen des Polarisators (115) beinhaltet.

7. Verfahren gemäß einem der Ansprüche 1 bis 4, wobei das photoausrichtbare Material lineares photopolymerisierbares Polymer (LPP) beinhaltet und es sich bei der polarisierten Strahlung um linear polarisiertes UV-Licht handelt.

8. Verfahren gemäß einem der Ansprüche 1 bis 4, wobei das LC-Material LC-Polymer beinhaltet und wobei Schritt (c) die folgenden Schritte beinhaltet:

Abscheiden eines LCP-Vorgängermaterials auf der Ausrichtungsschicht (20); und
Polymerisieren des LCP-Vorgängermaterials durch Belichten desselben mit UV-Licht, um die Verzögerungsplattenschicht (25) zu bilden.

**9.** Verfahren gemäß einem der Ansprüche 1 bis 4, wobei das LC-Material ein nematisches LC beinhaltet.

**10.** Verfahren gemäß Anspruch 9, wobei Schritt (c) das Bereitstellen einer zweiten Ausrichtungsschicht (30) beinhaltet, so dass die Verzögerungsplattenschicht (25) zwischen der ersten (20) und der zweiten (30) Ausrichtungsschicht angeordnet ist.

**11.** Verfahren gemäß Anspruch 10, wobei das nematische LC verdrehtes nematisches LC beinhaltet und wobei die zweite Ausrichtungsschicht (30) durch eine unidirektionale Ausrichtungsorientierung **gekennzeichnet** ist, die sich in einer Ebene der zweiten Ausrichtungsschicht nicht verändert.

**Revendications**

**1.** Un procédé de fabrication d'une lame d'onde à espace variant (10, 10a) comprenant les étapes consistant à :

a) fournir une première couche d'alignement (20) en un matériau photo-alignable sur un substrat (15) qui est substantiellement transparent ou réfléchissant pour un rayonnement optique dans une gamme de longueurs d'onde de fonctionnement ;
b) irradier une portion de la première couche d'alignement (20) avec un rayonnement polarisé via une ouverture (125) de manière à former une zone d'exposition (170, 170a) qui s'étend radialement à partir d'un point de centre (137a) sur la couche d'alignement (20) et à fournir un alignement à variation spatiale du matériau photo-alignable, le rayonnement polarisé ayant une longueur d'onde adéquate pour induire un alignement dans la couche d'alignement (20) ; et,
c) former une couche de lame d'onde (25) en un matériau à cristaux liquides sur la première couche d'alignement (20) de sorte que la couche de lame d'onde (25) ait un axe optique (33) qui varie dans un plan de la couche de lame d'onde en fonction de l'alignement à variation spatiale ;

**caractérisé en ce que**
l'étape b) consiste à faire tourner au moins deux éléments parmi la première couche d'alignement, l'ouverture et une orientation de polarisation du rayonnement polarisé à des vitesses angulaires sélectionnées de sorte que la zone d'exposition effectue au moins une rotation autour du point de centre,
dans lequel un rapport entre lesdites vitesses angulaires est sélectionné pour former dans la couche d'alignement un profil d'alignement de vortex (195) d'un ordre de vortex sélectionné $\alpha = m/2$ par rapport à des emplacements azimutaux sur la couche d'alignement (20), $m$ étant un entier non nul différent de 2, pour fournir à l'étape (c) un profil de vortex de l'ordre de vortex sélectionné $\alpha \neq 1$ pour l'axe optique de la couche de lame d'onde (25).

**2.** Un procédé de la revendication 1, dans lequel l'étape (b) consiste à effectuer au moins une rotation du substrat (15) à une première vitesse angulaire $\omega_1$ de manière à exposer différentes portions de la première couche d'alignement (20) au rayonnement polarisé via l'ouverture (125) à différents moments dans le temps, tout en faisant tourner l'orientation de polarisation du rayonnement polarisé à une deuxième vitesse angulaire $\omega_2$ qui est égale à (**1-m/2**)$\cdot\omega_1$, et tout en gardant l'ouverture (125) stationnaire avec une extrémité de l'ouverture positionnée sur un axe de rotation du substrat (15).

**3.** Un procédé de la revendication 1, dans lequel l'étape (b) consiste à effectuer au moins une rotation de l'ouverture (125) autour d'une extrémité (128) de celle-ci à une troisième vitesse angulaire $\omega_3$ de manière à exposer différentes portions de la première couche d'alignement (20) au rayonnement polarisé via l'ouverture (125) à différents moments dans le temps, tout en faisant tourner l'orientation de polarisation du rayonnement polarisé à une quatrième vitesse angulaire $\omega_4$ qui est égale à (m/2-1)$\cdot\omega_3$.

**4.** Un procédé de la revendication 1, dans lequel l'étape (b) consiste à faire tourner l'ouverture (125) à une cinquième vitesse angulaire $\omega_5$, tout en gardant l'orientation de polarisation du rayonnement polarisé stationnaire et en faisant tourner le substrat (15) à une sixième vitesse angulaire $\omega_6$ qui est égale à (1-2/m)$\cdot\omega_5$, de sorte que l'ouverture (125) effectue au moins une rotation complète relativement au substrat (15) autour du point de centre (137a) et que différentes portions de la première couche d'alignement (20) soient exposées au rayonnement polarisé via l'ouverture (125) à différents moments dans le temps.

5. Un procédé de l'une quelconque des revendications 2, 3 et 4, dans lequel l'ouverture (125) présente une portion en forme de coin avec une extrémité de sommet, et dans lequel l'extrémité de sommet est positionnée sur un axe (137) de rotation de l'ouverture (125) s'il y a rotation de l'ouverture à l'étape (b), ou sur un axe de rotation du substrat (15) s'il y a rotation du substrat à l'étape (b).

6. Un procédé de la revendication 2 ou la revendication 3, dans lequel l'étape (b) consiste à former le rayonnement polarisé en faisant passer un rayonnement UV au travers d'un polariseur (115), et consistant en outre à faire tourner le polariseur (115).

7. Un procédé de l'une quelconque des revendications 1 à 4, dans lequel le matériau photo-alignable comprend un polymère photo-polymérisable linéaire (LPP), et le rayonnement polarisé est de la lumière UV polarisée linéairement.

8. Un procédé de l'une quelconque des revendications 1 à 4, dans lequel le matériau CL comprend un polymère CL, et dans lequel l'étape (c) comprend les étapes consistant à :

déposer un matériau précurseur PCL sur la couche d'alignement (20) ; et,
polymériser le matériau précurseur PCL en exposant celui-ci à de la lumière UV pour former la couche de lame d'onde (25).

9. Un procédé de l'une quelconque des revendications 1 à 4, dans lequel le matériau CL comprend un CL nématique.

10. Un procédé de la revendication 9, dans lequel l'étape (c) consiste à fournir une deuxième couche d'alignement (30), de sorte que la couche de lame d'onde (25) est interposée entre la première couche d'alignement (20) et la deuxième couche d'alignement (30).

11. Un procédé de la revendication 10, dans lequel le CL nématique comprend un CL nématique en hélice, et dans lequel la deuxième couche d'alignement (30) est **caractérisée par** une orientation d'alignement unidirectionnelle qui ne varie pas dans un plan de la deuxième couche d'alignement.

**Radially
polarized light**

**Azimuthally
polarized light**

FIG. 1A (PRIOR ART)                    FIG. 1B(PRIOR ART)

FIG. 2A

FIG. 2B

FIG. 2C

FIG. 3

FIG. 4A

FIG. 4B

FIG. 5

FIG. 6

| Step | Details |
|---|---|
| Spin-coat adhesion promoter (ROM102/0.5IPA) | 60 s @2000 rpm, Suss coater |
| Spin-coat LPP (ROP108/2CP) | 60 s @3000 rpm, Suss coater |
| Bake | 10 min @180° C |
| LPUV exposure | 40 mJ/cm$^2$, with substrate azimuthally scanned 0.2 rpm (CW) under a 5$^c$ aperture. WGP/substrate rotation rate ratio R. |
| Spin-coat LCP (ROF5151/40AN) | 60 s @1000 rpm, Suss coater |
| Anneal | 10 min @53° C |
| UV cure | 3J/cm$^2$ UVA |
| Post-bake | 10 min @160° C |

FIG. 7

FIG. 8A

FIG. 8B

Providing an alignment layer on a
transparent or reflecting substrate ⟋ 310

↓

Exposing a portion of the alignment layer to LPUV
radiation through a wedge shaped aperture ⟋ 320

↓

Rotating two of: the alignment layer, the aperture
and a polarization of the UV radiation so as to
expose a disk area of the alignment layer to the
LPUV radiation ⟋ 330

↓

⟋ 340
Forming an LC waveplate layer on the alignment
layer

**FIG. 9**

10a

35

25

30
20

15

FIG. 10

FIG. 11

FIG. 12

EP 1 970 734 B1

FIG. 13

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6972906 B
- US 7190521 B
- US 20060126183 A
- US 20070115551 A
- US 2004179158 A

- US 5602661 A, Schadt
- US 5389689 A, Chigrinov
- US 5539074 A
- US 6201087 B
- US 6107427 A

**Non-patent literature cited in the description**

- **M. STALDER ; M. SCHADT.** Linearly polarized light with axial symmetry generated by liquid-crystal polarization converters. *Opt. Letts.,* 01 December 1996, vol. 21 (23), 1948-1950

- **Chen et al.** Radially an azimuthally oriented liquid crystal alignement patterns fabricated by linearly polarized ultraviolet light. *Appl. Phys. Lett.,* 12 February 1996, vol. 68 (7), 885-887
- **Seiberle et al.** Photo-Aligned Anisotropic Optical Thin Films. *SID 03 Digest,* 1162-116